(19) Europäisches Patentamt / European Patent Office / Office européen des brevets

(11) **EP 3 075 048 B1**

(12) **EUROPÄISCHE PATENTSCHRIFT**

(45) Veröffentlichungstag und Bekanntmachung des Hinweises auf die Patenterteilung:
**21.10.2020  Patentblatt 2020/43**

(21) Anmeldenummer: **14796486.0**

(22) Anmeldetag: **10.11.2014**

(51) Int Cl.:
*H02H 7/06* (2006.01)      *H02J 7/14* (2006.01)
*H02P 9/48* (2006.01)      *H02M 7/30* (2006.01)
*H03K 17/082* (2006.01)

(86) Internationale Anmeldenummer:
**PCT/EP2014/074133**

(87) Internationale Veröffentlichungsnummer:
**WO 2015/078685 (04.06.2015 Gazette 2015/22)**

(54) **ÜBERSPANNUNGSSCHUTZ FÜR KRAFTFAHRZEUGBORDNETZ BEI LASTABWURF**

OVERVOLTAGE PROTECTION FOR AN ON-BOARD POWER SUPPLY OF A MOTOR VEHICLE DURING A LOAD DUMP

PROTECTION CONTRE LES SURTENSIONS POUR RÉSEAU DE BORD DE VÉHICULE AUTOMOBILE EN CAS DE DÉLESTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.11.2013   DE 102013224106**

(43) Veröffentlichungstag der Anmeldung:
**05.10.2016   Patentblatt 2016/40**

(73) Patentinhaber: **SEG Automotive Germany GmbH 70499 Stuttgart (DE)**

(72) Erfinder:
• **OTTE, Christopher 72762 Reutlingen (DE)**
• **MEHRINGER, Paul 70569 Stuttgart (DE)**

(74) Vertreter: **Steinbauer, Florian et al Dehns Germany Theresienstraße 6-8 80333 München (DE)**

(56) Entgegenhaltungen:
EP-A2- 1 443 623          DE-A1-102008 041 099
DE-A1-102009 046 955

EP 3 075 048 B1

**Beschreibung**

Die vorliegende Erfindung betrifft ein Verfahren zum Betreiben eines Kraftfahrzeugbordnetzes und Mittel zur Implementierung des Verfahrens gemäß den Oberbegriffen der unabhängigen Patentansprüche.

Stand der Technik

Zur Speisung von Gleichstromsystemen aus Drehstromsystemen, beispielsweise von Kraftfahrzeugbordnetzen durch Drehstromgeneratoren, können Gleichrichter unterschiedlicher Bauart eingesetzt werden. In Kraftfahrzeugbordnetzen werden in Entsprechung zu den hier üblicherweise verbauten drei-, vier- oder fünfphasigen Drehstromgeneratoren üblicherweise Brückengleichrichter in sechs-, acht- oder zehnpulsiger Ausführung verwendet. Die Erfindung eignet sich jedoch auch für Brückengleichrichter für andere Phasenzahlen.

Ist nachfolgend vereinfacht von einem Generator die Rede, kann es sich hierbei auch um eine generatorisch und motorisch betreibbare elektrische Maschine handeln, beispielsweise um einen sogenannten Startergenerator.

Ein kritischer Betriebsfall bei Brückengleichrichtern ist der sogenannte Lastabwurf (engl. Load Dump). Dieser tritt auf, wenn sich bei hoch erregtem Generator und einem entsprechend hohen abgegebenen Strom die Last am Generator bzw. dem damit verbundenen Brückengleichrichter schlagartig verringert. Ein Lastabwurf kann entweder aus einer Abschaltung von Verbrauchern im angeschlossenen Bordnetz oder aus einem Kabelabriss resultieren.

Werden in einem batterielosen Betrieb des Bordnetzes Verbraucher schlagartig abgeschaltet, kann der Generator noch bis zu einer Sekunde lang mehr Energie liefern, als das Bordnetz aufnehmen kann. Falls diese Energie nicht oder nicht vollständig durch kapazitiv wirkende Elemente im Gleichspannungsnetz oder im Gleichrichter abgefangen werden kann, kann es zu Überspannungen und hierdurch zu Überspannungsschäden bei Komponenten im Kraftfahrzeugbordnetz kommen. In einem solchen Fall muss das Bordnetz jedoch weiter aus dem Generator versorgt werden, da eine Batterieversorgung als Übergangslösung nicht in Betracht kommt. So lange eine Batterie angeschlossen ist, ist ein Lastabwurf unkritisch. Nur im batterielosen Betrieb kann der Lastabfall Schäden hervorrufen. Der batterielose Betrieb stellt einen Fehlerfall dar.

Bei einem Kabelabriss am positiven Gleichspannungsanschluss des Brückengleichrichters liefert der Generator ebenfalls weiter Energie; es ist jedoch kein Verbraucher mehr angeschlossen. Im Vergleich zu dem soeben erläuterten Fall der Abschaltung von Verbrauchern im batterielosen Betrieb des Bordnetzes sind die Verbraucher nicht gefährdet. Gleichwohl kann es zu Überspannungen kommen, die die Leistungselektronik des Generators schädigen können.

In herkömmlichen (passiven) Brückengleichrichtern erfolgt jeweils ein gewisser Schutz des Bordnetzes bzw. der Leistungselektronik des Generators durch den Gleichrichter selbst, nämlich mittels der dort klassischerweise verbauten Gleichrichter-Zenerdioden, in denen die Überspannung geklammert und die überschüssige Energie in Wärme umgesetzt werden kann.

Wie beispielsweise in der DE 10 2009 046 955 A1 erläutert, ist jedoch in Kraftfahrzeugen der Einsatz von aktiven bzw. gesteuerten Brückengleichrichtern wünschenswert. Dies ist unter anderem deshalb der Fall, weil aktive Brückengleichrichter im Gegensatz zu passiven bzw. ungesteuerten Brückengleichrichtern geringere Verlustleistungen im Normalbetrieb aufweisen. Derzeit erhältliche ansteuerbare bzw. aktive Schaltelemente für solche aktiven Brückengleichrichter, beispielsweise MOSFET, besitzen jedoch keine integrierte Klammerfunktion mit einer ausreichenden Robustheit wie herkömmliche Gleichrichter-Zenerdioden und können daher die Überspannung nicht abfangen. Daher sind in aktiven Brückengleichrichtern zusätzliche Schutzstrategien erforderlich.

Bei einem Lastabwurf können beispielsweise die Generatorphasen kurzgeschlossen werden, indem einige oder alle Schaltelemente des oberen oder unteren Gleichrichterzweigs eines entsprechenden Gleichrichters kurzzeitig leitend geschaltet werden, wie beispielsweise auch in der DE 198 35 316 A1 offenbart und in der DE 10 2009 046 955 A1 diskutiert. Dies erfolgt insbesondere auf Grundlage einer Auswertung der an den Gleichspannungsanschlüssen des aktiven Brückengleichrichters anliegenden Ausgangsspannung. Überschreitet diese einen vorgegebenen oberen Schwellwert, wird ein entsprechender Kurzschluss eingeleitet und die Ausgangsspannung sinkt. Unterschreitet die Ausgangsspannung danach einen vorgegebenen unteren Schwellwert, wird der Kurzschluss aufgehoben und die Ausgangsspannung steigt erneut an. Es handelt sich somit um ein typisches Hystereseverhalten. Die Ausgangsspannung pendelt daher bei einem Lastabwurf zwischen dem oberen und dem unteren Schwellwert.

In EP 1443623, die als nächstliegender Stand der Technik betrachtet wird, ist ein Kraftfahrzeug-Bordnetz mit einer Lichtmaschine offenbart, die antriebsmäßig mit einem Fahrzeugmotor verbunden ist und die mehrphasige Lichtmaschine antreibt, um eine mehrphasige Wechselspannung zu erzeugen. Die Schaltelemente der Lichtmaschine werden entsprechend bei einem Lastabfall in einem Kurzschlussbetriebsmodus betrieben, um entsprechend überschüssige Energie abzubauen.

Diese aus dem Stand der Technik bekannten Lösungen erweisen sich jedoch nicht immer als günstig, so dass der Bedarf nach verbesserten Schutzstrategien für aktive Brückengleichrichter bei Lastabwurf besteht.

Offenbarung der Erfindung

Vor diesem Hintergrund schlägt die Erfindung ein Verfahren zum Betreiben eines Kraftfahrzeugbordnetzes und Mittel zur Implementierung des Verfahrens mit den Merkmalen der unabhängigen Patentansprüche vor. Ausgestaltungen sind Gegenstand der Unteransprüche und der nachfolgenden Beschreibung.

Vorteile der Erfindung

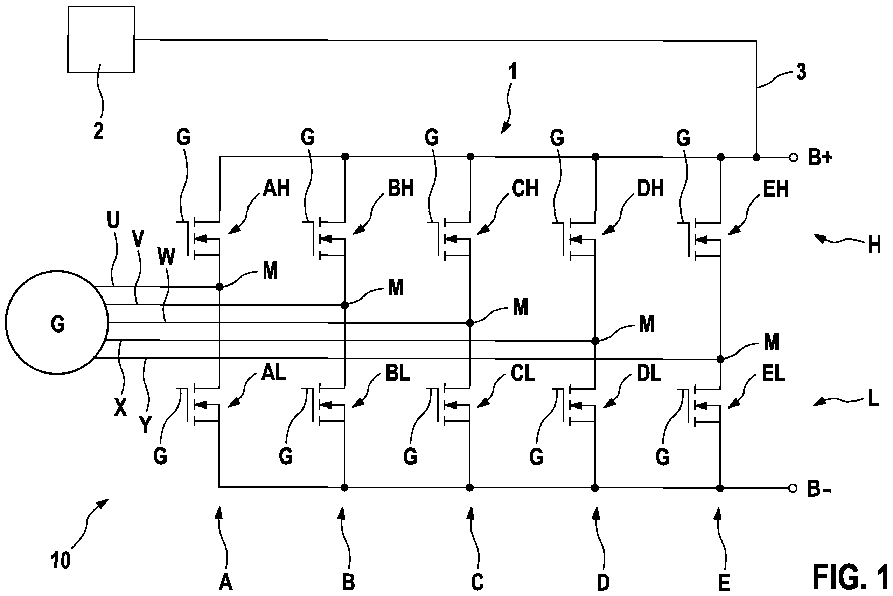

Ein Kraftfahrzeugbordnetz bzw. eine elektrische Maschine mit einem Brückengleichrichter und einer Steuereinrichtung eines solchen Kraftfahrzeugbordnetzes, das der vorliegenden Erfindung zugrunde liegen kann, wird unter Bezugnahme auf die Figur 1 unten näher erläutert.

Die vorliegende Erfindung geht von einem Verfahren zum Betreiben eines derartigen Kraftfahrzeugbordnetzes mit einer generatorisch betreibbaren elektrischen Maschine und einem über Phasenanschlüsse mit der elektrischen Maschine verbundenen aktiven Brückengleichrichter, der in einem Gleichrichterbetriebsmodus und in einem Kurzschlussbetriebsmodus betreibbar ist, aus.

Im Rahmen dieser Anmeldung wird dabei unter einem "Gleichrichterbetriebsmodus" ein Betriebsmodus verstanden, wie er zur regulären Gleichrichtung bei Abwesenheit von Lastabwürfen sowie nach einem Lastabwurf zwischen den nachfolgend erläuterten Kurzschlussbetriebsmodi verwendet wird. Ein derartiger Gleichrichterbetriebsmodus umfasst, an den Phasenanschlüssen anliegende Phasenspannungen durch Ansteuern von aktiven Schaltelementen des Brückengleichrichters in eine Ausgangsspannung zu wandeln, die an Gleichspannungsanschlüssen des Brückengleichrichters ausgegeben wird. Ein derartiger Gleichrichterbetriebsmodus ist insoweit bekannt. Typischerweise wird hierbei eine an den jeweiligen Phasenanschlüssen anliegende positive Halbwelle zu einem positiven Gleichspannungsanschluss (hier mit B+ bezeichnet), eine an einem entsprechenden Phasenanschluss anliegende negative Halbwelle hingegen zu einem negativen Gleichspannungsanschluss (B-) durchgeschaltet. Hierzu werden die jeweiligen MOSFET bzw. aktiven Schaltelemente in den Gleichrichterbrücken eines entsprechenden Brückengleichrichters geeignet beschaltet, wie auch unter Bezugnahme auf die Figur 1 erläutert.

In dem Kurzschlussbetriebsmodus werden hingegen die Phasenanschlüsse durch Ansteuern der aktiven Schaltelemente kurzgeschlossen, so dass an den Gleichspannungsanschlüssen des Brückengleichrichters von dem Brückengleichrichter keine Ausgangsspannung ausgegeben wird. Wird ein entsprechendes Bordnetz in einem Kurzschlussbetriebsmodus nicht auf andere Weise versorgt, sinkt die an den Gleichspannungsanschlüssen detektierbare Spannung, und damit die Spannung im Bordnetz, ab.

Wie zuvor erläutert und insoweit ebenfalls bekannt, wird bei einem erkannten Lastabwurf, beispielsweise dann, wenn ein Signal, das eine Spannung kennzeichnet, die zwischen den Gleichspannungsanschlüssen des Brückengleichrichters abfällt, einen oberen Schwellwert überschreitet, ein Kurzschlussbetriebsmodus eingeleitet. Der Kurzschlussbetriebsmodus wird solange aufrechterhalten, so lange das Signal hiernach keinen unteren Schwellwert unterschreitet. Bekannt ist auch, wie erläutert, den Kurzschlussbetriebsmodus aufzuheben, sobald das erläuterte Signal in einem Kurzschlussbetriebsmodus einen unteren Schwellwert unterschreitet.

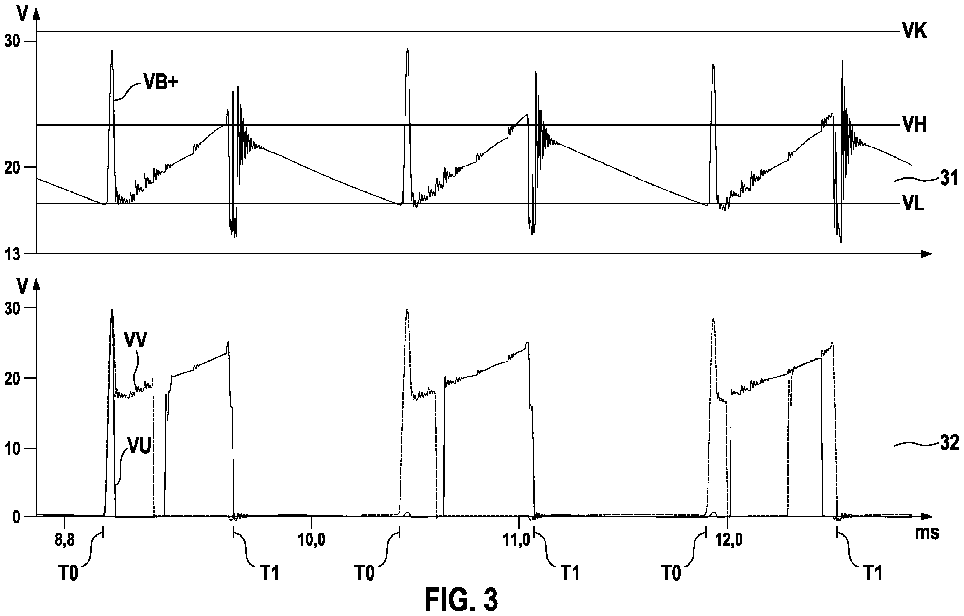

Das Signal, das die zwischen den Gleichspannungsanschlüssen des Brückengleichrichters anliegende Spannung kennzeichnet, muss dabei nicht ein Rohsignal, beispielsweise eine entsprechend gemessene Spannung, darstellen: Um beispielsweise eine Fehlerkennung bei Spannungsspitzen, die nur kurzfristig auftreten, zu vermeiden, kann ein entsprechendes Signal auch insbesondere gefiltert werden. Dies ist vor allem bei Signalformen erforderlich, wie sie in Figur 3 und dem dortigen Diagramm 31 veranschaulicht sind. Hier kommt es beim Aufheben eines entsprechenden Phasenkurzschlusses zu einer kurzzeitigen Spannungsspitze (vgl. Zeitpunkt T0), die eine entsprechende Erkennungsschwelle VH überschreitet. Würde ein ungefiltertes Signal eingesetzt, würde bereits zu diesem Zeitpunkt ein soeben eingeleiteter Kurzschluss wieder aufgehoben.

Zum Ansteuern der aktiven Schaltelemente wird dabei vorzugsweise ein Ansteuersignal mit einer definierten Schaltzeit verwendet. Eine im Rahmen der vorliegenden Erfindung in einer ersten Verfahrensphase verwendete Schaltzeit wird hier als "erste Schaltzeit" bezeichnet.

Es ist bekannt, dass aktive Schaltelemente bei einer Ansteuerung mit einem Signal mit flachen Signalflanken (also bei einer längeren Schaltzeit) auch nur vergleichsweise langsam von dem sperrenden in den leitenden Zustand übergehen. Hierdurch lassen sich beim Schalten induktiver Lasten an einem Gleichrichter Spannungsspitzen vermeiden: Wie allgemein bekannt, richtet sich der Durchlasswiderstand zwischen Drain und Source bei Transistoren, wie beispielsweise den erwähnten MOSFET, nach der zwischen Gate und Source anliegenden Spannung. Unterhalb einer sogenannten Grenzspannung (engl. Threshold Voltage) ist die Verbindung zwischen Drain und Source über den Transistor hochohmig, oberhalb dieser niederohmig. Der Durchlasswiderstand fällt bei Erreichen der Grenzspannung jedoch nicht schlagartig auf seinen Minimalwert, bei dem dieser entsprechend dem gängigen Sprachgebrauch "durchgesteuert" ist. Vielmehr bricht der Widerstand bei einer Erhöhung der Spannung zwischen Gate und Source über die Grenzspannung zwar zunächst stark ein, jedoch nur auf einen bestimmten Wert oberhalb seines Minimalwerts. Erst wenn die am Gate anliegende Spannung weiter erhöht wird, beispielsweise um 1 bis 2 V, stellt sich der minimale Durchlasswiderstand ein. Wird daher dieser Bereich mit einem Ansteuersignal langsam durchlaufen, lässt sich ein entsprechend "langsames" Schalten des Transistors erzielen.

Dieses "langsame" Schalten ist insbesondere von Vorteil beim Einleiten und insbesondere Aufheben der erläuterten Kurzschlüsse bei einem Lastabwurf, bei dem das Bordnetz noch an den Gleichrichter angeschlossen ist (also nicht bei einem Lastabwurf aufgrund eines Kabelabrisses). Hierbei stellen die Leitungen des Bordnetzes induktive Lasten dar, so dass es zu Spannungsspitzen kommen kann. Es empfiehlt sich daher, in solchen Fällen längere Schaltzeiten zu verwenden, so dass sich die Spannungsspitzen reduzieren. Weil jedoch die beteiligten Transistoren hierbei vergleichsweise stark belastet werden, und weil es im regulären Gleichrichterbetrieb bei einem "langsamen" Schalten zu erhöhten Verlustleistungen kommt, wird eine entsprechende längere Schaltzeit vorteilhafterweise nur dann verwendet, wenn sie tatsächlich erforderlich ist.

Erfindungsgemäß ist vorgesehen, nachdem der Brückengleichrichter in der ersten Verfahrensphase zumindest einmal in dem Kurzschlussbetriebsmodus betrieben wurde, auf Grundlage zumindest eines Merkmals des Signals, das die zwischen den Gleichspannungsanschlüssen des Brückengleichrichters anliegende Spannung kennzeichnet, zu bestimmen, ob das Signal den oberen Schwellwert aufgrund eines Kabelabrisses eines Kabels an zumindest einem der Gleichspannungsanschlüsse überschritten hat. Ist dies der Fall, wird der Brückengleichrichter anschließend in einer zweiten Verfahrensphase für einen verlängerten Zeitraum in dem Kurzschlussbetriebsmodus betrieben und/oder es wird in der zweiten Verfahrensphase zum Ansteuern der aktiven Schaltelemente ein Ansteuersignal mit einer zweiten, Schaltzeit, die kürzer als die erste Schaltzeit ist, verwendet. Letzteres ist insbesondere deshalb vorteilhaft, weil bei einem erkannten Kabelabriss keine induktiven Lasten geschaltet werden müssen und daher eine kürzere Schaltzeit (mit geringerer Belastung der verwendeten Transistoren) verwendet werden kann. Da in einem solchen Fall auch nicht auf die (vom Gleichrichter getrennten) Komponenten eines Bordnetzes Rücksicht genommen werden muss, kann auch ein verlängerter Zeitraum für den Kurzschlussbetriebsmodus verwendet werden. Auf diese Weise werden die Transistoren ebenfalls geschont.

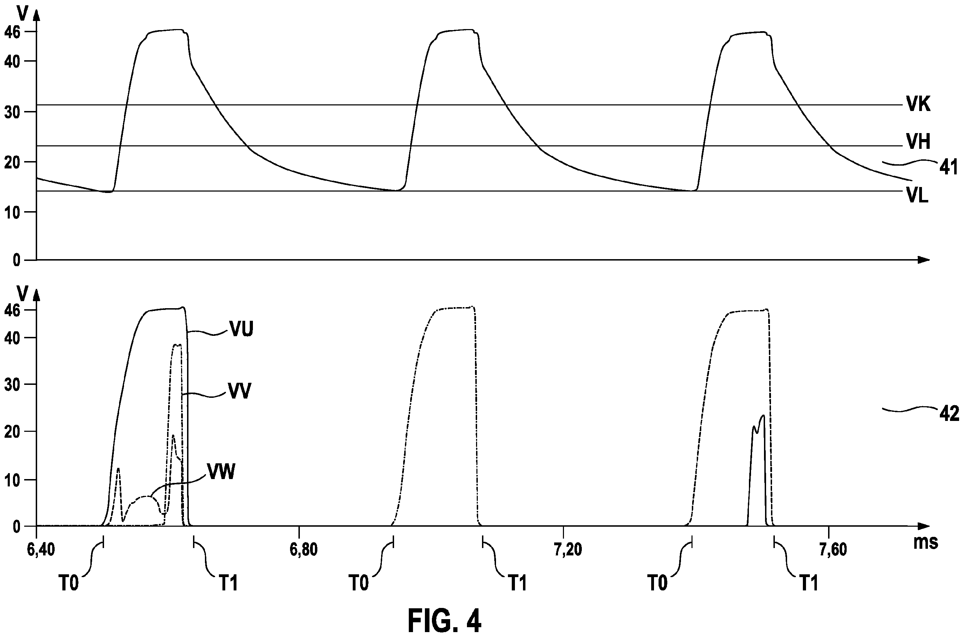

Wie auch nachfolgend erläutert, kann als Kriterium dafür, ob das Signal den oberen Schwellwert aufgrund eines Kabelabrisses überschritten hat, eine Dauer des zumindest einen Kurzschlussbetriebsmodus verwendet werden. Dies wird nachfolgend auch noch unter Bezugnahme auf die Figuren 3 und 4 veranschaulicht. Entsprechend kann auch ein Überschreiten eines Erkennungsschwellwerts nach Beginn des zumindest einen Kurzschlussbetriebsmodus verwendet werden. Wie ebenfalls nachfolgend erläutert, kommt es beim Abschalten von Verbrauchern, nicht jedoch bei einem Kabelabriss, zu einem Spannungseinbruch nach Beginn des Kurzschlussbetriebsmodus, was ebenfalls als Kriterium zur Unterscheidung verwendet werden kann.

Die "Verlängerung" des Zeitraums, in dem der Brückengleichrichter in der zweiten Verfahrensphase in dem Kurzschlussbetriebsmodus betrieben wird, kann beispielsweise durch Vorgeben einer entsprechenden Kurzschlussbetriebsmoduszeit, insbesondere von 0 bis 1,5 Sekunden, beispielsweise von 0,5 bis 1 Sekunden, erfolgen. In einer derartigen Zeit sind Überspannungen bzw. entsprechende Generatorleistungen abgebaut. Eine Verlängerung eines Kurzschlussbetriebsmodus kann auch dadurch erfolgen, dass der untere Schwellwert herabgesetzt wird, also der Kurzschlussbetriebsmodus verzögert aufgehoben wird.

Die im Rahmen der vorliegenden Erfindung verwendbaren ersten und zweiten Schaltzeiten liegen insbesondere in einem Bereich von 10 bis 200 $\mu$s (erste Schaltzeit) und in einem Bereich von 0 bis 20 $\mu$s (zweite Schaltzeit).

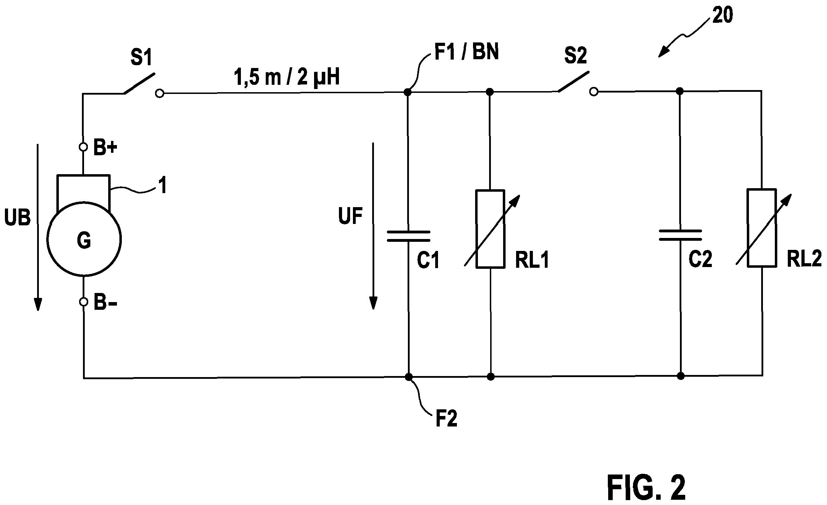

Bei der Wahl der ersten Schaltzeit sind insbesondere der Generatorstrom I_Generator zum Zeitpunkt des Schaltvorgangs und die Bordnetzinduktivität L_Bordnetz zwischen dem Gleichrichter und einem Kondensator im Bordnetz (vgl. Kondensator C1 gemäß Figur 2) zu berücksichtigen. Die induzierte Spannung U_induziert genügt der Gleichung

$$U\_induziert = L\_Bordnetz \times dI\_Generator / dt$$

Je höher die Bordnetzinduktivität und je niedriger die zulässige induzierte Spannung ist, desto langsamer muss der Schaltvorgang gewählt werden.

Auch eine Anpassung von Filterzeiten, die zur Bereitstellung des Signals verwendet werden, das die zwischen den Gleichspannungsanschlüssen des Brückengleichrichters anliegende Spannung kennzeichnet, kann erfolgen. Durch deren Reduzierung kann die Zeit, in der die Schaltelemente einer Belastung ausgesetzt sind (vgl. Zeitraum T1 - T0 gemäß Figur 4) reduziert werden.

Eine erfindungsgemäße Recheneinheit, z.B. eine Steuereinrichtung eines aktiven Brückengleichrichters eines Kraftfahrzeugbordnetzes, ist insbesondere programmtechnisch dazu eingerichtet, das Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben.

Kurze Beschreibung der Zeichnungen

Figur 1     zeigt ein Bordnetz mit einem Brückengleichrichter, einem Generator und einer Steuereinrichtung in schematischer Teildarstellung.

Figur 2     zeigt eine Anordnung zur Simulation von Lastabwürfen in einem Bordnetz in schematischer Darstellung.

Figur 3     zeigt Strom- und Spannungsverläufe bei einem Lastabwurf aufgrund einer Abschaltung von Verbrauchern in Form von Diagrammen.

Figur 4     zeigt Strom- und Spannungsverläufe bei einem Lastabwurf aufgrund eines Kabelabrisses in Form von Diagrammen.

In den Figuren zeigen einander entsprechende Elemente identische Bezugszeichen und werden der Übersichtlichkeit halber nicht wiederholt erläutert.

Ausführungsform(en) der Erfindung

In Figur 1 ist eine herkömmliche Anordnung mit einem Brückengleichrichter 1 und einem Generator G am Beispiel eines fünfphasigen Systems schematisch dargestellt. Der Brückengleichrichter 1 ist in Figur 1 als zehnpulsiger Brückengleichrichter dargestellt, der zur Gleichrichtung eines Drehstroms eines fünfphasigen Generators G eingerichtet ist. In gleicher Weise kann jedoch beispielsweise auch ein drei-, vier-, sechs- oder siebenphasiger Generator G und ein entsprechend hieran angepasster sechs-, acht- zwölf- oder vierzehnpulsiger Brückengleichrichter 1 eingesetzt werden. Der Brückengleichrichter 1 ist Teil eines hier nur teilweise dargestellten Bordnetzes 10.

Der Brückengleichrichter 1 weist fünf Halbbrücken A bis E auf, die jeweils über ihren Mittelabgriff M mit den fünf Generatorphasen bzw. entsprechenden Phasenanschlüssen U bis Y verbunden sind.

Die Halbbrücken A bis E sind mit ihren Enden jeweils mit den Gleichspannungsanschlüssen B+ und B-, beispielsweise Batteriepolen und/oder entsprechenden Versorgungsleitungen eines Bordnetzes 100, verbunden. Der Anschluss B- kann dabei mit Masse verbunden sein.

Die Halbbrücken A bis E weisen jeweils aktive Schaltelemente AH bis EH und AL bis EL auf, die hier als MOSFET veranschaulicht sind. Diese sind jeweils in einen oberen Zweig H (Highside) und einen unteren Zweig L (Lowside) der einzelnen Halbbrücken A bis E eingebunden.

Die Phasenanschlüsse U bis Y können nach Maßgabe einer entsprechenden Beschaltung der aktiven Schaltelemente AH bis EH und AL bis EL jeweils mit einem der beiden Gleichspannungsanschlüsse B+ oder B- verbunden werden. Werden zwei oder mehr Phasenanschlüsse U bis Y jeweils mit demselben Gleichspannungsanschluss B+ bzw. B- verbunden, kommt dies einem Kurzschließen dieser Phasenanschlüsse U bis Y über den jeweiligen Gleichspannungsanschluss B+ bzw. B- gleich.

Die Beschaltung der aktiven Schaltelemente AH bis EH und AL bis EL erfolgt über ihre jeweiligen Gate-Anschlüsse G durch eine Steuereinrichtung 2 über nicht dargestellte Ansteuerleitungen. Dabei kann eine Steuereinrichtung 2 für alle Halbbrücken A bis E gemeinsam vorgesehen sein. Alternativ dazu kann auch jede der Halbbrücken A bis E eine individuelle Steuereinrichtung aufweisen. Ist letzteres der Fall, können Funktionen beliebig zwischen individuellen Steuereinrichtungen und einer gemeinsamen Steuereinrichtung 2 verteilt sein.

Der Normalbetrieb des Brückengleichrichters 1 umfasst, die aktiven Schaltelemente AH bis EH und AL bis EL derart anzusteuern, dass an den Phasenanschlüssen U bis Y anliegende Stromsignale, abhängig von der Stromrichtung, abwechselnd nach B+ und B- durchgesteuert werden.

Ein Lastabwurf kann in einer in Figur 1 dargestellten Anordnung beispielsweise auf Grundlage einer an dem Gleichspannungsanschluss B+ anliegenden Spannung detektiert werden. Hierzu ist die Steuereinrichtung 2 über eine Leitung 3 mit dem Gleichspannungsanschluss B+ verbunden. Wird ein definierter Spannungsschwellwert überschritten, liegt ein Lastabwurf vor.

Die Ansteuerung des Gleichrichters 1 bei einem erkannten Lastabwurf kann umfassen, die Phasenanschlüsse U bis Y zeitlich definiert kurzzuschließen. In der Folge fällt der in das Bordnetz eingespeiste Strom auf Null ab, die über die Leitung 3 erfasste Spannung sinkt. Ein entsprechender Kurzschluss kann durch ein gleichzeitiges Ansteuern und damit Leitendschalten einiger oder aller Schaltelemente AH bis EH einerseits oder AL bis EL andererseits, also einiger oder aller Schaltelemente eines Gleichrichterzweigs H oder L hergestellt werden. Wird ein solcher Kurzschluss gelöst, steigen der in das Bordnetz eingespeiste Strom und die über die Leitung 3 erfasste Spannung wieder an.

In Figur 2 ist eine Schaltung zum Simulieren von Lastabwürfen in einem Bordnetz eines Kraftfahrzeugs dargestellt und insgesamt mit 20 bezeichnet. Die Schaltung 20 stellt gleichzeitig ein Ersatzschaltbild eines Bordnetzes 10 dar, in das ein Generator G und ein Gleichrichter 1, beispielsweise wie in der zuvor erläuterten Figur 1 dargestellt, eingebunden sind. Wie erläutert, kann ein entsprechendes Bordnetz auch Generatoren G und/oder Gleichrichter 1 mit anderer Phasen- bzw. Pulszahl aufweisen.

An dem Generator G mit dem Gleichrichter 1 liegt hierbei eine Spannung UB an, wie durch einen entsprechend beschrifteten Pfeil veranschaulicht. Die Kondensatoren C1 und C2 sowie die Lastwiderstände RL1 und RL2 repräsentieren Kapazitäten bzw. Widerstände eines realen Bordnetzes. Der Kondensator C1 entspricht dabei einem Kondensator an einem Fremdstartstützpunkt, der zum Fremdstarten des entsprechenden Kraftfahrzeugs vorgesehen ist. Die Anschlüsse F1 und F2 sind dabei zur Starthilfe vorgesehen. An einem Punkt BN, der dem Anschluss F1 entsprechen kann, kann eine Bordnetzspannung, beispielsweise gegen Masse oder den Anschluss F2, gemessen werden. Der Kondensator C1 ist unter anderem dazu vorgesehen, Spannungsschwankungen im Bordnetz abzupuffern. Die über den Kondensator C1 abfallende Spannung ist ebenfalls mit einem Pfeil veranschaulicht und mit UF bezeichnet.

Es ist zu beachten, dass in üblichen Kraftfahrzeugen der Generator B mit dem Gleichrichter 1 einerseits und der Kondensator C1 andererseits bzw. auch schon der Punkt BN bzw. die Anschlüsse F1 und F2 durch Leitungen mit einer Länge von typischerweise 1,5 bis 2 Metern und einem Querschnitt von beispielsweise 25 Quadratmillimetern voneinander getrennt sind. Nachfolgend werden die Gleichspannungsanschlüsse des Gleichrichters, B+ und B- demgegenüber als Anschlüsse betrachtet, die direkt am Gleichrichter vorgesehen sind. Beispielsweise die Anschlüsse F1 und F2 und der Punkt BN sind hiervon, wie erläutert, durch entsprechende Leitungslängen getrennt.

Die erläuterten Leitungen mit den genannten Eigenschaften entsprechen im elektrischen Ersatzschaltbild im Wesentlichen Induktivitäten. Diese Induktivitäten sind dafür verantwortlich, dass es bei schnellen Stromänderungen an den Gleichspannungsanschlüssen B+ und B- des Gleichrichters 1 zu induzierten Spannungsspitzen kommt. Die Spannungen am Fremdstartstützpunkt, d.h. die Spannung UF, die zwischen den Anschlüssen F1 und F2 bzw. dem Punkt BN gegen Masse abfällt, kann daher nicht direkt von einer am Generator G bzw. dem Gleichrichter 1 angebrachten Elektronik erfasst werden. Die vorliegende Erfindung berücksichtigt auch dies.

Ist im Folgenden von "Spannungen am Gleichrichter" die Rede, handelt es sich hierbei um Spannungen, die direkt am Gleichrichter 1, also beispielsweise am Anschluss B+ gemessen werden können. Diese werden auch mit VB+ bezeichnet. Aufgrund der erläuterten Induktivitäten der Leitungen unterscheiden sich die zeitlichen Verläufe dieser Spannungen ggf. von den entsprechenden zeitlichen Verläufen von "Spannungen am Bordnetz", die beispielsweise am Anschluss F1 bzw. dem Punkt BN gemessen werden können. Eine Kabellänge zwischen dem Schalter S1 (siehe unten) und dem Punkt BN bzw. dem Anschluss F1 kann beispielsweise, wie in Figur 2 gezeigt, 1,5 m betragen, die Induktivität eines entsprechenden Kabels liegt beispielsweise bei 2 μH.

Zur Simulation von Lastabwürfen sind Schalter S1 und S2 vorgesehen. Zu Beginn eines Lastabwurftests bzw. einer entsprechenden Simulation sind beide Schalter S1 und S2 geschlossen. Der Generator G bzw. der Gleichrichter 1 gibt einen Strom an das Bordnetz ab, der sich aus den Lastwiderständen RL1 und RL2 ergibt. Ein Lastabwurf kann durch das Öffnen eines der Schalter S1 bzw. S2 nachgebildet werden. Das Öffnen des Schalters S1 entspricht damit einem Lastabfall auf 0%, wie er in der Realität beispielsweise durch den Abfall des Anschlusskabels am Generator (Kabelabriss) verursacht würde. Das Öffnen des Schalters S2 bildet dagegen einen teilweisen Lastabfall nach, wie er durch die Abschaltung einer größeren resistiven Last, hier RL2, im Bordnetz verursacht wird. Die Höhe des "abgeworfenen" Laststroms lässt sich durch den Widerstandswert des Lastwiderstands RL2 einstellen, die Höhe des restlichen Bordnetzstroms durch den Widerstand des Lastwiderstands RL1.

In den Figuren 3 und 4 sind jeweils Diagramme mit Spannungsverläufen am positiven Gleichspannungsanschluss B+ (Diagramme 31 bzw. 41) bzw. an ausgewählten Phasenanschlüssen (Diagramme 32 bzw. 42) in V auf der Ordinate gegenüber einer Zeit in ms auf der Abszisse dargestellt.

In Figur 3 sind dabei Spannungsverläufe gezeigt, wie sie typischerweise aus Lastabwürfen resultieren, die sich aus einer Abschaltung von Verbrauchern in einem Bordnetz ergeben. Das in dem Diagramm 31 dargestellte Spannungssignal VB+ kann hierbei durch Messung einer zwischen den B+ und B- eines Brückengleichrichters erhalten werden (vgl. Figur 1). Ein entsprechendes Spannungssignal VB+, wie es in Diagramm 31 dargestellt ist, ergibt sich insbesondere im batterielosen Betrieb und bei Abschaltung eines Hochlastverbrauchers.

In den in Figur 3 dargestellten Diagrammen wird dabei jeweils zu den Zeitpunkten T0 ein Phasenkurzschluss, wie er zuvor erläutert wurde, aufgehoben. Zum Zeitpunkt T0 ergibt sich hierdurch jeweils eine markante Spannungsspitze aufgrund der mehrfach erläuterten Leitungsinduktivitäten im Bordnetz. Nachdem die Bordnetzinduktivität den Generatorstrom komplett übernommen hat, nimmt die Spannung an B+ den Wert der Bordnetzspannung BN wieder an. Der Spannungswert nach der Spannungsspitze entspricht im Wesentlichen dem Spannungswert vor der Spannungsspitze. Dieser Spannungswert wird durch die Charakteristik eines verwendeten Hystereseglieds vorgegeben, dessen unterer Schwellwert in dem im Diagramm 31 mit VL bezeichnet ist. Anschließend steigt die Spannung VB+ kontinuierlich an. Kurz vor dem Zeitpunkt T1 erreicht die Spannung VB+ jeweils einen oberen Schwellwert VH, hier etwa 23,5 V.

Aufgrund einer entsprechenden Schwellwerterkennung wird zu einem Zeitpunkt T1 ein Phasenkurzschluss, wie zuvor erläutert, eingeleitet. Hierdurch kommt es zunächst zu einem deutlichen Spannungseinbruch in dem Spannungssignal VB+, der spezifisch als Erkennungsmerkmal für Lastabwürfe ist, die sich aufgrund einer Abschaltung von Verbrauchern im Bordnetz (nicht jedoch einem Kabelabriss am Generator) ergeben.

Durch das Kurzschließen der Phasenanschlüsse zwischen den Zeitpunkten T1 und T0 (also in einem Kurzschlussbetriebsmodus) sinkt die Spannung VB+ ab und erreicht kurz vor dem Zeitpunkt T0 einen unteren Schwellwert VL, hier etwa 17 V, der wie beschrieben durch den unteren Schwellwert des Hystereseglieds in der Steuereinheit einstellbar ist.

Ein weiterer Schwellwert, hier mit VK bezeichnet, kann ebenfalls zur Unterscheidung zwischen Lastabwürfen, die aus der Abschaltung von Verbrauchern einerseits und aus Kabelabrissen andererseits resultieren, verwendet werden. Der Schwellwert VK wird im Diagramm 31, also bei der Abschaltung von Verbrauchern, durch das Signal VB+ niemals erreicht, so dass auf dieser Grundlage festgestellt werden kann, das kein Kabelabriss vorliegt.

In dem Diagramm 32 sind zur Veranschaulichung zwei der fünf Phasenspannungen, wie sie an den Phasenanschlüssen U bis Y einer entsprechenden elektrischen Maschine bzw. eines Generators G (vgl. Figur 1) anliegen, veranschaulicht. Es handelt sich hierbei um die Spannungen an den Phasenanschlüssen U und V, hier mit VU und VV bezeichnet. Aufgrund des Phasenkurzschlusses zwischen den Zeitpunkten T1 und T0 sinken die Spannungen auf 0 V ab.

Wie bereits erläutert, entspricht die Darstellung in den Diagrammen 41 und 42 der Figur 4 im Wesentlichen der Darstellung in den Diagrammen 31 und 32 der Figur 3. In der Figur 4 sind jedoch Lastabwürfe veranschaulicht, die sich aufgrund eines Kabelabrisses ergeben. In dem Diagramm 42 sind ferner drei Spannungssignale an den Phasenanschlüssen einer elektrischen Maschine G dargestellt und hier mit VU, VV und VW bezeichnet.

Wie im Vergleich der Figur 3 und 4 ersichtlich, ist der zeitliche Abstand zwischen der Lösung des Kurzschlusses T0 und der erneuten Einleitung eines entsprechenden Kurzschlusses T1 bei einem Kabelabriss (Figur 4) deutlich kürzer als bei der Abschaltung eines Verbrauchers im Bordnetz. Gemäß Figur 4 handelt es sich hierbei um ca. 0,15 ms, gemäß Figur 3 um ca. 0,60 ms. Dieser Unterschied kann als Merkmal zur Unterscheidung der genannten Ursachen für Lastabwürfe herangezogen werden.

Ferner ist insbesondere aus einem Vergleich der Diagramme 41 und 31 ersichtlich, dass es beim Aktivieren eines Phasenkurzschlusses zu den Zeitpunkten T1 bei einem Lastabwurf aufgrund eines Kabelabrisses (Figur 4) kaum zu Spannungseinbrüchen kommt. Dies ist darauf zurückzuführen, dass bei einem Kabelabriss kein Strom in einer Induktivität eines Bordnetzes umkommutiert werden muss.

Ein weiteres Kriterium, das die Unterscheidung zwischen den genannten Ursachen für Lastabwürfe erlaubt, ist die Überschreitung des bereits bzgl. Figur 3 erläuterten Schwellwerts VK. Da sich bei einem Kabelabriss deutlich höhere Spannungen (hier bis zu 46 V) ergeben, wird der Schwellwert VK überschritten, so dass eine entsprechende Überschreitung als weiteres Kriterium für einen Kabelabriss verursachten Lastabwurf verwendet werden kann.

Wie aus Diagramm 32 ersichtlich, steigt die Spannung VB+ beim Lösen eines Phasenkurzschlusses kurzzeitig deutlich über die eigentliche Schaltschwelle an. Sie springt anschließend sehr schnell wieder auf die ursprüngliche Spannung (wie zuvor erläutert etwa 17 V) zurück. Erst anschließend erhöht sich die Spannung VB+ durch das Laden der Bordnetzkapazität wieder allmählich (d.h. in einem Zeitraum von ca. 0,6ms), bis die Aktivierungsschwelle VH für den Phasenkurzschluss wieder überschritten wird.

Im Gegensatz dazu erkennt man in Diagramm 41, dass bei einem Kabelabriss die Spannung auf einen sehr hohen Wert (wie erwähnt beinahe 46 V) ansteigt, dann jedoch (zunächst) dort verharrt. Dies ist auf die Klammerwirkung des Avalanche-Durchbruchs der beteiligten Transistoren zurückzuführen. Falls in einem entsprechenden Gleichrichter zusätzliche Elemente zur Klammerung vorgesehen sind, wie grundsätzlich ebenfalls möglich, kann diese Spannung auch unterhalb der Avalanche-Spannung der verwendeten Transistoren liegen.

Sofern die Spannungsspitze in Diagramm 31 aufgrund einer höheren Bordnetzinduktivität oder einer schnelleren Schaltgeschwindigkeit den Wert VK erreicht, kann die Unterscheidung dahingehend erweitert werden, dass die Zeit ausgewertet wird, bei der das Signal VB+ den Schwellwert VK übersteigt.

Die Dauer der Spannungsspitze bzw. eines entsprechenden Spannungsplateaus in dem Signal VB+ kann daher als Kriterium genutzt werden, ob ein induktiver Strom geschaltet wird, oder ein Kabelabriss vorliegt. Dauert eine entsprechende Spannungsspitze länger, als es aufgrund der Bordnetzinduktivität und des geschalteten Stroms plausibel ist, kann davon ausgegangen werden, dass ein Kabelabriss vorliegt.

**Patentansprüche**

1. Verfahren (100) zum Betreiben eines Kraftfahrzeugbordnetzes (10) mit einer generatorisch betreibbaren elektrischen Maschine (G) und einem über Phasenanschlüsse (VU - VY) mit der elektrischen Maschine (G) verbundenen aktiven Brückengleichrichter (1), der in einem Gleichrichterbetriebsmodus und einem Kurzschlussbetriebsmodus betreibbar ist, bei dem

   - in dem Gleichrichterbetriebsmodus an den Phasenanschlüssen (U - Y) anliegende Phasenspannungen (VU - VY) durch Ansteuern von aktiven Schaltelementen (AH - EL) des Brückengleichrichters (1) in eine Ausgangsspannung gewandelt werden, die an Gleichspannungsanschlüssen (B+, B-) des Brückengleichrichters (1) ausgegeben wird,
   - in dem Kurzschlussbetriebsmodus die Phasenanschlüsse (U - Y) durch Ansteuern der aktiven Schaltelemente (AH - EL) kurzgeschlossen werden, so dass an den Gleichspannungsanschlüssen (B+, B-) des Brückengleichrichters (1) von dem Brückengleichrichter (1) keine Ausgangsspannung ausgegeben wird, und
   - der Kurzschlussbetriebsmodus eingeleitet wird, sobald ein Signal (VB+), das eine Spannung kennzeichnet, die zwischen den Gleichspannungsanschlüssen (B+, B-) des Brückengleichrichters (1) abfällt, einen oberen Schwellwert (VH) überschreitet, wobei
   - in einer ersten Verfahrensphase der Kurzschlussbetriebsmodus aufgehoben wird, sobald das Signal (VB+) danach einen unteren Schwellwert unterschreitet und zum Ansteuern der aktiven Schaltelemente (AH - EL) ein Ansteuersignal mit einer ersten Schaltzeit verwendet wird,
   **dadurch gekennzeichnet, dass**
   - nachdem der Brückengleichrichter (1) in der ersten Verfahrensphase zumindest einmal in dem Kurzschlussbetriebsmodus betrieben wurde, auf Grundlage zumindest eines Merkmals des Signals (VB+) bestimmt wird, ob das Signal (VB+) den oberen Schwellwert (VH) aufgrund eines Kabelabrisses eines Kabels an zumindest einem der Gleichspannungsanschlüsse (B+, B-) überschritten hat, wobei als das zumindest eine Merkmal des Signals (VB+) eine Dauer des zumindest einen Kurzschlussbetriebsmodus, in dem der Brückengleichrichter (1) in der ersten Verfahrensphase betrieben wurde, verwendet wird,
   und wenn dies der Fall ist,
   - der Brückengleichrichter (1) anschließend

     in einer zweiten Verfahrensphase für einen verlängerten Zeitraum in dem Kurzschlussbetriebsmodus betrieben wird, indem eine entsprechende Kurzschlussbetriebsmoduszeit vorgegeben oder der untere Schwellwert (VL) herabgesetzt wird, und/oder
     in der zweiten Verfahrensphase zum Ansteuern der aktiven Schaltelemente (AH - EL) ein Ansteuersignal mit einer zweiten Schaltzeit, die kürzer als die ersten Schaltzeit ist, verwendet wird.

2. Verfahren (100) nach Anspruch 1, bei dem als das zumindest eine Merkmal des Signals (VB+) ein fehlender Spannungseinbruch nach Beginn des zumindest einen Kurzschlussbetriebsmodus, in dem der Brückengleichrichter (1) in der ersten Verfahrensphase betrieben wurde, verwendet wird.

3. Verfahren (100) nach einem der vorstehenden Ansprüche, bei dem als das zumindest eine Merkmal des Signals (VB+) ein Überschreiten eines Erkennungsschwellwerts (VK) nach Beginn des zumindest einen Kurzschlussbetriebsmodus, in dem der Brückengleichrichter (1) in der ersten Verfahrensphase betrieben wurde, verwendet wird.

4. Verfahren (100) nach einem der vorstehenden Ansprüche, bei dem der Brückengleichrichter (1) in der zweiten Verfahrensphase für 0 bis 1,5 s, insbesondere für 0,5 bis 1 s in dem Kurzschlussbetriebsmodus betrieben wird.

5. Verfahren (100) nach einem der vorstehenden Ansprüche, bei dem in der zweiten Verfahrensphase zum Ansteuern der aktiven Schaltelemente (AH - EL) ein Ansteuersignal mit der zweiten Schaltzeit verwendet wird, wobei die erste Schaltzeit in einem Bereich von 10 bis 200 µs und die zweite Schaltzeit in einem Bereich von 0 bis 20 µs liegt.

6. Verfahren (100) nach einem der vorstehenden Ansprüche, bei dem das Signal (VB+) gefiltert wird, wobei in der ersten Verfahrensphase eine erste und in der zweiten Verfahrensphase eine zweite Filterzeit verwendet wird.

7. Kraftfahrzeugbordnetz (10) mit einer generatorisch betreibbaren elektrischen Maschine (G) und mit einem über Phasenanschlüsse (VU - VY) mit der elektrischen Maschine (G) verbundenen aktiven Brückengleichrichter (1), der in einem Gleichrichterbetriebsmodus und einem Kurzschlussbetriebsmodus betreibbar ist, und mit einer Steuereinrichtung (2), die eingerichtet ist,

- in dem Gleichrichterbetriebsmodus an den Phasenanschlüssen (U - Y) anliegende Phasenspannungen (VU - VY) durch Ansteuern von aktiven Schaltelementen (AH - EL) des Brückengleichrichters (1) in eine Ausgangsspannung zu wandeln, die an Gleichspannungsanschlüssen (B+, B-) des Brückengleichrichters (1) ausgegeben wird,

- in dem Kurzschlussbetriebsmodus die Phasenanschlüsse (U - Y) durch Ansteuern der aktiven Schaltelemente (AH - EL) kurzzuschließen, so dass an den Gleichspannungsanschlüssen (B+, B-) des Brückengleichrichters (1) von dem Brückengleichrichter (1) keine Ausgangsspannung ausgegeben wird, und

- den Kurzschlussbetriebsmodus einzuleiten, sobald ein Signal (VB+), das eine Spannung kennzeichnet, die zwischen den Gleichspannungsanschlüssen (B+, B-) des Brückengleichrichters (1) abfällt, einen oberen Schwellwert (VH) überschreitet, wobei die Steuereinrichtung (2) ferner eingerichtet ist,

- in einer ersten Verfahrensphase den Kurzschlussbetriebsmodus aufzuheben, sobald das Signal (VB+) danach einen unteren Schwellwert unterschreitet und zum Ansteuern der aktiven Schaltelemente (AH - EL) ein Ansteuersignal mit einer ersten Schaltzeit zu verwenden,

**dadurch gekennzeichnet, dass** die Steuereinrichtung (2), eingerichtet ist,

- nachdem der Brückengleichrichter (1) in der ersten Verfahrensphase zumindest einmal in dem Kurzschlussbetriebsmodus betrieben wurde, auf Grundlage zumindest eines Merkmals des Signals (VB+) zu bestimmen, ob das Signal (VB+) den oberen Schwellwert (VH) aufgrund eines Kabelabrisses eines Kabels an zumindest einem der Gleichspannungsanschlüsse (B+, B-) überschritten hat, wobei als das zumindest eine Merkmal des Signals (VB+) eine Dauer des zumindest einen Kurzschlussbetriebsmodus, in dem der Brückengleichrichter (1) in der ersten Verfahrensphase betrieben wurde, verwendet wird, und wenn dies der Fall ist,

- den Brückengleichrichter (1) anschließend

in einer zweiten Verfahrensphase für einen verlängerten Zeitraum in dem Kurzschlussbetriebsmodus zu betreiben, indem eine entsprechende Kurzschlussbetriebsmoduszeit vorgegeben oder der untere Schwellwert (VL) herabgesetzt wird, und/oder

in der zweiten Verfahrensphase zum Ansteuern der aktiven Schaltelemente (AH - EL) ein Ansteuersignal mit einer zweiten Schaltzeit, die kürzer als die ersten Schaltzeit ist, zu verwenden.

8. Steuereinrichtung (2), die eingerichtet ist, ein Verfahren nach einem der Ansprüche 1 bis 6 durchzuführen.

9. Computerprogramm, das eine Steuereinrichtung (2) dazu veranlasst, ein Verfahren nach einem der Ansprüche 1 bis 6 durchzuführen, wenn es auf der Steuereinrichtung (2) ausgeführt wird.

**Claims**

1. Method (100) for operating a motor vehicle on-board network (10) having an electrical machine (G) which can be operated as a generator and having an active bridge rectifier (1) which is connected to the electrical machine (G) via phase connections (VU - VY) and can be operated in a rectifier operating mode and a short-circuit operating mode, wherein

- in the rectifier operating mode, phase voltages (VU - VY) present at the phase terminals (U - Y) are converted by driving active switching elements (AH - EL) of the bridge rectifier (1) into an output voltage which is output at DC voltage terminals (B+, B-) of the bridge rectifier (1),

- in the short-circuit operating mode, the phase terminals (U - Y) are shortcircuited by driving the active switching elements (AH - EL) so that no output voltage is output from the bridge rectifier (1) at the DC voltage terminals (B+, B-) of the bridge rectifier (1), and

- the short-circuit operating mode is initiated as soon as a signal (VB+) indicative of a voltage which drops between the DC voltage terminals (B+, B-) of the bridge rectifier (1) exceeds an upper threshold value (VH), wherein

- in a first method phase, the short-circuit operating mode is cancelled as soon as the signal (VB+) subsequently falls below a lower threshold value, and a driving signal with a first switching time is used to drive the active switching elements (AH - EL),

**characterized in that**

- after the bridge rectifier (1) has been operated at least once in the short-circuit operating mode in the first method phase, it is determined on the basis of at least one feature of the signal (VB+) whether the signal (VB+) exceeds the upper threshold value (VH) due to a cable break in a cable at at least one of the DC voltage terminals (B+, B-), wherein a duration of the at least one short-circuit operating mode in which the bridge rectifier (1) was operated in the first method phase is used as the at least one feature of the signal (VB+),
and if that is the case,
- the bridge rectifier (1) then

is operated in the short-circuit operating mode for a prolonged period of time in a second method phase by presetting a corresponding short-circuit operating mode time or lowering the lower threshold value (VL), and/or
in the second method phase, a driving signal with a second switching time which is shorter than the first switching time is used to drive the active switching elements (AH - EL).

2. Method (100) according to claim 1, wherein a missing voltage dip after the start of the at least one short-circuit operating mode in which the bridge rectifier (1) was operated in the first method phase is used as the at least one feature of the signal (VB+).

3. Method (100) according to any one of the preceding claims, wherein an exceedance of a detection threshold (VK) after the start of the at least one short-circuit operating mode in which the bridge rectifier (1) was operated in the first method phase is used as the at least one feature of the signal (VB+).

4. Method (100) according to any one of the preceding claims, wherein the bridge rectifier (1) is operated in the second method phase for 0 to 1.5 s, in particular for 0.5 to 1 s in the short-circuit operating mode.

5. Method (100) according to any one of the preceding claims, wherein in the second method phase a driving signal with the second switching time is used to drive the active switching elements (AH - EL), wherein the first switching time is in a range of 10 to 200 $\mu$s and the second switching time is in a range of 0 to 20 $\mu$s.

6. Method (100) according to any one of the preceding claims, wherein the signal (VB+) is filtered, wherein a first filter time is used in the first method phase and a second filter time is used in the second method phase.

7. Motor vehicle on-board network (10) having an electrical machine (G) which can be operated as a generator and having an active bridge rectifier (1) which is connected to the electrical machine (G) via phase connections (VU - VY) and can be operated in a rectifier operating mode and a short-circuit operating mode, and having a control device (2) which is configured

- in the rectifier operating mode, to convert phase voltages (VU - VY) present at the phase terminals (U - Y) by driving active switching elements (AH - EL) of the bridge rectifier (1) into an output voltage which is output at DC voltage terminals (B+, B-) of the bridge rectifier (1),
- in the short-circuit operating mode, to short-circuit the phase terminals (U - Y) by driving the active switching elements (AH - EL) so that no output voltage is output from the bridge rectifier (1) at the DC voltage terminals (B+, B-) of the bridge rectifier (1), and
- to initiate the short-circuit operating mode as soon as a signal (VB+) indicative of a voltage which drops between the DC voltage terminals (B+, B-) of the bridge rectifier (1) exceeds an upper threshold value (VH), wherein the control device (2) is further configured
- in a first method phase, to cancel the short-circuit operating mode as soon as the signal (VB+) subsequently falls below a lower threshold value, and to use a driving signal with a first switching time to drive the active switching elements (AH - EL),
**characterized in that** the control device (2) is configured
- after the bridge rectifier (1) has been operated at least once in the short-circuit operating mode in the first method phase, to determine, on the basis of at least one feature of the signal (VB+), whether the signal (VB+) exceeds the upper threshold value (VH) due to a cable break in a cable at at least one of the DC voltage terminals (B+, B-), wherein a duration of the at least one short-circuit operating mode in which the bridge rectifier (1) was operated in the first phase of the method is used as the at least one feature of the signal (VB+),
and if that is the case,
- to operate the bridge rectifier (1) then

in a second method phase for a prolonged period of time in the short-circuit operating mode by presetting a corresponding short-circuit operating mode time or lowering the lower threshold value (VL), and/or
in the second method phase, to use a drive signal with a second switching time which is shorter than the first switching time to drive the active switching elements (AH - EL).

8. Control device (2) configured to perform a method according to any one of claims 1 to 6.

9. Computer program that causes a control device (2) to perform a process according to any one of claims 1 to 6 when executed on the control device (2).

**Revendications**

1. Procédé (100) pour faire fonctionner un réseau de bord de véhicule (10) comportant une machine électrique (G) pouvant fonctionner en mode générateur et un redresseur en pont actif (1) relié à la machine électrique (G) par l'intermédiaire de bornes de phase (VU - VY), lequel redresseur en pont pouvant fonctionner dans un mode de fonctionnement en redresseur et un mode de fonctionnement en court-circuit, dans lequel

   - dans le mode de fonctionnement en redresseur, des tensions de phase (VU - VY) présentes aux bornes de phase (U - Y) sont converties en une tension de sortie en commandant des éléments de commutation actifs (AH - EL) du redresseur en pont (1), laquelle tension étant générée au niveau des bornes de tension continue (B+, B-) du redresseur en pont (1),
   - dans le mode de fonctionnement en court-circuit, les bornes de phase (U - Y) sont mises en court-circuit en commandant les éléments de commutation actifs (AH - EL), de sorte qu'aucune tension de sortie n'est délivrée par le redresseur en pont (1) aux bornes de tension continue (B+, B-) du redresseur en pont (1), et
   - le mode de fonctionnement en court-circuit est déclenché dès qu'un signal (VB+) caractérisant une tension qui chute entre les bornes de tension continue (B+, B-) du redresseur en pont (1), franchit une valeur de seuil supérieure (VH), dans lequel
   - dans une première phase de procédé, le mode de fonctionnement en court-circuit est annulé dès que le signal (VB+) franchit ensuite une valeur de seuil inférieure et un signal de commande avec un premier temps de commutation est utilisé pour commander les éléments de commutation actifs (AH - EL),
   **caractérisé en ce que**
   - dans la première phase de procédé, après que le redresseur en pont (1) a fonctionné au moins une fois dans le mode de fonctionnement en court-circuit, sur la base d'au moins une caractéristique du signal (VB+), il est déterminé si le signal (VB+) a franchi la valeur de seuil supérieure (VH) en raison d'une rupture de câble sur au moins une des bornes de tension continue (B+, B-), une durée du au moins un mode de fonctionnement en court-circuit dans lequel le redresseur en pont (1) a fonctionné dans la première phase de procédé, étant utilisée comme la au moins une caractéristique du signal (VB+),
   et si tel est le cas,
   - ensuite le redresseur en pont (1)
   fonctionne, dans une seconde phase de procédé, dans le mode de fonctionnement en court-circuit pendant une durée prolongée, en prédéfinissant un temps de mode de fonctionnement en court-circuit correspondant ou en réduisant la valeur de seuil inférieure (VL), et/ou
   dans la seconde phase de procédé, un signal de commande avec un second temps de commutation plus court que le premier temps de commutation, est utilisé pour commander les éléments de commutation actifs (AH - EL).

2. Procédé (100) selon la revendication 1, dans lequel l'absence de baisse de tension après le début du au moins un mode de fonctionnement en mode de court-circuit, dans lequel le redresseur en pont (1) a fonctionné dans la première phase de procédé, est utilisée comme la au moins une caractéristique du signal (VB+).

3. Procédé (100) selon l'une des revendications précédentes, dans lequel un dépassement d'une valeur de seuil de détection (VK) après le début du au moins un mode de fonctionnement en mode de court-circuit, dans lequel le redresseur en pont (1) a fonctionné dans la première phase de procédé, est utilisé comme la au moins une caractéristique du signal (VB+).

4. Procédé (100) selon l'une des revendications précédentes, dans lequel le redresseur en pont (1) fonctionne dans la seconde phase de procédé pendant 0 à 1,5 s, en particulier pendant 0,5 à 1 s dans le mode de fonctionnement en court-circuit.

5. Procédé (100) selon l'une des revendications précédentes, dans lequel dans la seconde phase de procédé, un signal de commande avec le second temps de commutation est utilisé pour commander les éléments de commutation actifs (AH - EL), le premier temps commutation étant dans une plage de 10 à 200 $\mu$s et le second temps de commutation est dans une plage de 0 à 20 $\mu$s.

**6.** Procédé (100) selon l'une des revendications précédentes, dans lequel le signal (VB+) est filtré, un premier temps de filtrage étant utilisé dans la première phase de procédé et un second temps de filtrage étant utilisé dans la seconde phase de procédé.

**7.** Réseau de bord de véhicule (10) comportant une machine électrique (G) pouvant fonctionner en mode générateur et un redresseur en pont actif (1) relié à la machine électrique (G) par l'intermédiaire de bornes de phase (VU - VY), lequel redresseur en pont pouvant fonctionner dans un mode de fonctionnement en redresseur et un mode de fonctionnement en court-circuit, et comportant un dispositif de commande (2) qui est configuré pour :

- convertir, dans le mode de fonctionnement en redresseur, des tensions de phase (VU - VY) présentes aux bornes de phase (U - Y) en une tension de sortie en commandant des éléments de commutation actifs (AH - EL) du redresseur en pont (1), laquelle tension de sortie étant générée au niveau des bornes de tension continue (B+, B-) du redresseur en pont (1),
- mettre en court-circuit, dans le mode de fonctionnement en court-circuit, les bornes de phase (U - Y) en commandant les éléments de commutation actifs (AH - EL), de sorte qu'aucune tension de sortie n'est délivrée par le redresseur en pont (1) aux bornes de tension continue (B+, B-) du redresseur en pont (1), et
- déclencher le mode de fonctionnement en court-circuit dès qu'un signal (VB+) caractérisant une tension qui chute entre les bornes de tension continue (B+, B-) du redresseur en pont (1), franchit une valeur de seuil supérieur (VH), le dispositif de commande (2) étant en outre configuré pour :
- annuler, dans une première phase de procédé, le mode de fonctionnement en court-circuit dès que le signal (VB+) franchit ensuite une valeur de seuil inférieure et utiliser un signal de commande avec un premier temps de commutation pour commander les éléments de commutation actifs (AH - EL),
**caractérisé en ce que** le dispositif de commande (2) est configuré pour :
- déterminer, après que le redresseur en pont (1) dans la première phase de procédé a fonctionné au moins une fois dans le mode de fonctionnement en court-circuit, sur la base d'au moins une caractéristique du signal (VB+), déterminer si le signal (VB+) a franchi la valeur de seuil supérieure (VH) en raison d'une rupture de câble sur au moins une des bornes de tension continue (B+, B-), dans lequel une durée du au moins un mode de fonctionnement en court-circuit dans lequel le redresseur en pont (1) a fonctionné dans la première phase de procédé, est utilisée comme la au moins une caractéristique du signal (VB+),
et si tel est le cas,
ensuite
- dans une seconde phase de procédé, faire fonctionner le redresseur en pont (1) dans le mode de fonctionnement en court-circuit pendant une durée prolongée, en prédéfinissant un temps de mode de fonctionnement en court-circuit correspondant ou en réduisant la valeur de seuil inférieure (VL), et/ou dans la seconde phase de procédé, utiliser un signal de commande avec un second temps de commutation plus court que le premier temps de commutation, pour commander les éléments de commutation actifs (AH - EL).

**8.** Dispositif de commande (2) conçu pour mettre en œuvre un procédé selon l'une des revendications 1 à 6.

**9.** Programme informatique permettant à un dispositif de commande (2) de mettre en œuvre un procédé selon l'une des revendications 1 à 6, lorsqu'il est exécuté sur le dispositif de commande (2).

FIG. 1

FIG. 2

**FIG. 3**

EP 3 075 048 B1

**FIG. 4**

**IN DER BESCHREIBUNG AUFGEFÜHRTE DOKUMENTE**

**In der Beschreibung aufgeführte Patentdokumente**

- DE 102009046955 A1
- DE 19835316 A1

- EP 1443623 A